# EUROPEAN PATENT APPLICATION

(11) **EP 4 576 183 A1**
(43) Date of publication of application: **25.06.2025**
(21) Application number: 24220413.9
(22) Date of filing: 17.12.2024
(51) Int. Cl.: H01L 21/74, H01L 23/535, H01L 23/538, H01L 23/498, H01L 23/522, H01L 23/00, H01L 25/065

(54) **SEMICONDUCTOR DIE WITH BURIED ELECTRICAL INTERCONNECTIONS**

(30) Priority: 20.12.2023 IN 202341087415
(71) Applicant: NXP B.V., 5656 AG Eindhoven (NL)
(72) Inventor: REBER, Douglas Michael, 5656AG Eindhoven (NL); BHOOSHAN, Rishi, 5656AG Eindhoven (NL)
(74) Representative: Colaiuda, Antonella

(57) **Abstract**

One or more electrical interconnects are formed beneath a device region within a volume of semiconductor material in which electronic devices are formed. The buried interconnects extended in a lateral direction parallel to surfaces of the die toward an edge of the semiconductor die. Such buried interconnects can be exposed at edges of the die to provide electrical contacts along those edges and can be coupled to electronic devices formed within the device region as alternatives to or in addition to contacts formed on top or bottom surfaces of the die.

## Description

### TECHNICAL FIELD

Embodiments of the subject matter described herein relate to semiconductor-based integrated circuits and forming electrical interconnections within such circuits and between semiconductor die and other structures.

### BACKGROUND

Semiconductor devices formed on or within individual semiconductor die include both electrical interconnections between devices on the same die as well as electrical interconnections tied to contact structures on top or bottom surfaces of a die that allow external devices to be coupled to the circuits formed on or within the semiconductor die.

### SUMMARY

In an example embodiment an electronic component includes a first semiconductor die having an upper surface, a lower surface, and a first volume of semiconductor material between the upper surface and the lower surface. Electronic devices are integrally formed in a first device region that forms part of the first volume of semiconductor material. The component further includes a first electrically-conductive buried interconnect formed within the first volume of semiconductor material between the first device region and the lower surface of the first semiconductor die. The buried interconnect extends from an interior portion of the first semiconductor die to a first edge of the first semiconductor die along a lateral direction that is parallel to the upper and lower surfaces of the first semiconductor die. The first edge extends between the upper surface and the lower surface of the first semiconductor die and the first buried interconnect is exposed at the first edge of the first semiconductor die.

In another example embodiment an electronic component includes a first semiconductor die having an upper surface, a lower surface, and a first volume of semiconductor material between the upper surface and the lower surface. Electronic devices integrally formed in a first device region that forms part of the first volume of semiconductor material. A first electrically-conductive buried interconnect is formed within the first volume of semiconductor material between the first device region and the lower surface of the first semiconductor die. The first buried interconnect extends along a lateral direction that is parallel to the upper and lower surfaces of the first semiconductor die; and the first buried interconnect is electrically coupled to one or more of the electronic devices of the first device region.

### BRIEF DESCRIPTION OF THE DRAWINGS

The present disclosure is illustrated by way of examples, embodiments and the like and is not limited by the accompanying figures, in which like reference numbers indicate similar elements. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIG. 1A is a cross-sectional view of a semiconductor die according to one or more embodiments;
FIG. 1B is top plan view of the semiconductor die of FIG. 1A;
FIG. 2 is a process flow diagram corresponding to an example process suitable for fabricating die according to embodiment herein such as the die of FIG. 1A and FIG. 1B;
FIG. 3 is a process flow diagram corresponding to another example process suitable for fabricating a die according to embodiment herein;
FIG. 4 is a process flow diagram corresponding to yet another example process suitable for fabricating a die according to one or more embodiments embodiment herein;
FIG. 5 is a cross-sectional view of a semiconductor die according to one or more embodiments in which buried interconnects can be used to couple multiple devices or other structures to a supply voltage node, a reference voltage node, or to a signal node;
FIG. 6 is a cross-sectional view of a semiconductor die according to one or more embodiments in which buried interconnects can be used to form part of an electrical shielding structure;
FIG. 7 is a cross-sectional view of a semiconductor die according to one or more embodiments in which buried interconnects can be used to provide edge contacts to one or more devices within a semiconductor die;
FIG. 8 is a cross-sectional view of an example component according to one or more embodiments in which buried interconnects can be used to provide edge contacts that allow coupling of two side-by-side semiconductor die; and
FIG. 9 is a cross-sectional view of an example component according to one or more embodiments in which buried interconnects can be used to provide edge contacts that allow coupling of side-by-side semiconductor die and/or vertically stacked semiconductor die.

### DETAILED DESCRIPTION

The following detailed description provides examples for the purposes of understanding and is not intended to limit the invention or the application and uses of the same. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring the invention. Additionally, elements in the drawing figures are not necessarily drawn to scale. For example, the dimensions of some of the elements or regions in the figures may be exaggerated relative to other elements or regions to help improve understanding of embodiments of the invention.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose.

Directional references such as "top," "bottom," "left," "right," "above," "below," and so forth, unless otherwise stated, are not intended to require any preferred orientation and are made with reference to the orientation of the corresponding figure or figures for purposes of illustration.

It will be appreciated that the steps of various processes described herein are non-limiting examples of suitable processes according to embodiments and are for the purposes of illustration. Embodiments herein may use any suitable processes including those that omit steps of example processes described herein, perform those steps or similar steps in different orders, and the like. It will also be appreciated that well-known techniques and features may be omitted for clarity.

Unless explicitly stated otherwise, the terms "approximately" and "substantially", when used herein to refer to measurable quantities including, but not limited to dimensions, shall mean that a quantity is equal to a stated value or that two quantities are equal to each other to within an amount determined by accepted tolerances of the process(es) chosen to fabricate the relevant structure and/or an accepted measurement accuracy of the method(s) and/or measurement device(s) chosen to measure the dimensions or other properties described.

Conventional approaches to providing external contacts to devices formed on or within semiconductor die such as copper pillars or other structures which require through-substrate vias can have disadvantage. For example, through-substrate vias and related structures can cause mechanical stresses in surrounded portions of a die. These mechanical stresses can result in variations in device performance which can be difficult to predict or otherwise undesirable. As a result, it may be necessary to implement design rules to ensure that vias or other interconnect structures are kept away from transistors and other sensitive devices. But such approaches can increase the minimum footprint of a die leading to increased manufacturing costs, among other potential disadvantages.

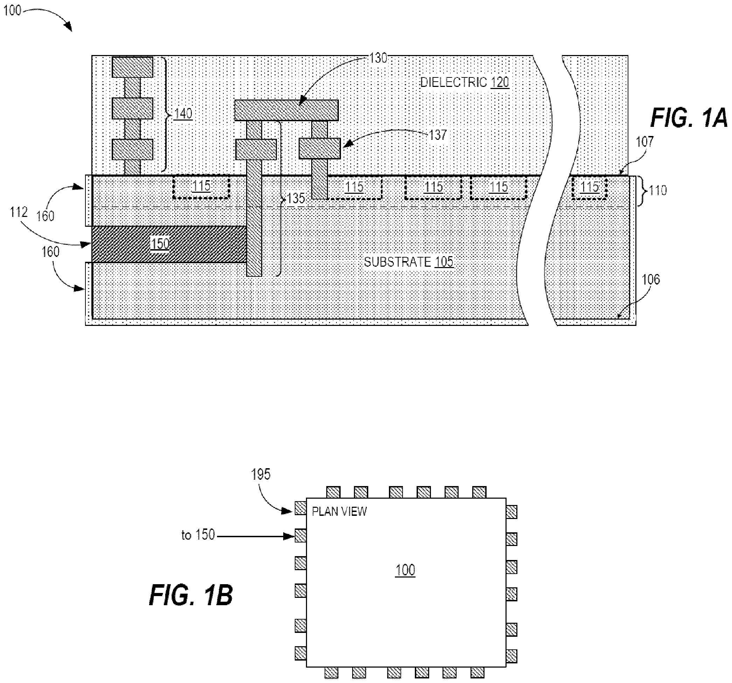

Accordingly, embodiments described herein provide additional flexibility to route electrical interconnections within a semiconductor die using buried electrical interconnects that can run parallel the upper and lower surfaces of a semiconductor die which can reduce or eliminate the need for electrical interconnections that pass through a substrate in proximity to sensitive devices. Along these lines, FIG. 1A shows a cross-sectional view of an example semiconductor die according to one or more embodiments with a buried electrical interconnect which facilitates electrical connections to the die via edge contacts rather than (or in addition to) contacts on a top or bottom surface of the die. The die 100 includes a substrate 105 with semiconductor devices 115 integrally formed a volume of semiconductor material having a lower surface 106, and an upper surface 107. The devices 115 can be transistors or any other suitable devices and are fabricated within a device region 110. An electrically conductive buried interconnect 150 extends horizontally from an interior of the substrate 105 toward an edge 112 of the substrate 105. The buried interconnect 150 may be formed from any suitable electrically-conductive materials including, but not limited to, metals such as tungsten, copper, nickel, silicide compounds of such metals, polysilicon, and the like.

In one or more embodiments, a buried interconnect such as the buried interconnect 150 is surrounded by a dielectric material (not explicitly shown) that electrically isolates the buried interconnect from the semiconductor material of the substrate 105 that immediately surrounds it. A dielectric layer 120 (or multiple dielectric layers 120) can include electrically conductive buried interconnects 150 which extended horizontally and can be coupled to vias including through-substrate vias ("TSVs") such as the TSV 135. The term TSV is used herein to refer to vias or similar structures which pass through all or part of a semiconductor substrate such as the substrate 105 and similar substrates, as described herein. Dielectric layers such as the dielectric layer(s) 120 disposed on a surface of a die that include electrical interconnections routed within them may be referred to as a redistribution layer, or "RDL" (or as multiple redistribution layers or "RDLs"), or one or more "build-up layers." As shown in FIG. 1A, a buried interconnect such as the buried interconnect 150 can be electrically coupled to a through-substrate via or other conductive structure such as the TSV 135. In the example FIG. 1A the TSV 135 is coupled to another electrically conductive interconnect 130 which extends horizontally and can be coupled to one or more devices 115 or another vertical interconnect as desired. For example, in FIG. 1A, the buried interconnect 150 is coupled to one of the devices 115 via an interconnect 137.

In one or more embodiments, a semiconductor die includes a seal-ring structure such as the seal ring structure 140. In this example, the seal ring structure 140 can be formed together with structures such as horizontal interconnects such as the interconnect 130 and vertical interconnects such as the TSV 135 or the interconnect 137. A seal ring structure such as the seal ring 140 may form a continuous structure along the perimeter of a die such as the die 100. A structure such as the seal ring 140 need not be electrically coupled to any other structure and can be used to protect sensitive portions of a semiconductor die such as the die 100 (e.g., devices 115) from damage due to mechanical processes such as wafer dicing (i.e., singulating the die from a larger die or wafer) or chemical processes. As shown, a dielectric material 160 may be deposited or otherwise formed on the edge 112 and/or the lower surface 106 to electrically insulate the substrate 105. The dielectric material may be removed (or prevented from being formed) to expose a portion of the buried interconnect 150 at the edge 112. Any suitable material can be used for the dielectric material 160 including, but not limited, to polymeric materials, oxide materials, nitride materials, and so on.

In one or more such embodiments, a buried interconnect can pass underneath the seal ring structure such as the seal ring 140 as shown in FIG. 1A. Such an arrangement can be desirable because it allows for electrical contacts (via one or more buried interconnects such as the buried interconnect 150) to be routed to an exterior surface (e.g., an edge 112) of a die without interfering with the seal ring, as further illustrated by FIG. 1B shows a simplified top view of the die 100 in which multiple external contact pads 195 are coupled to one or more buried interconnects 150.

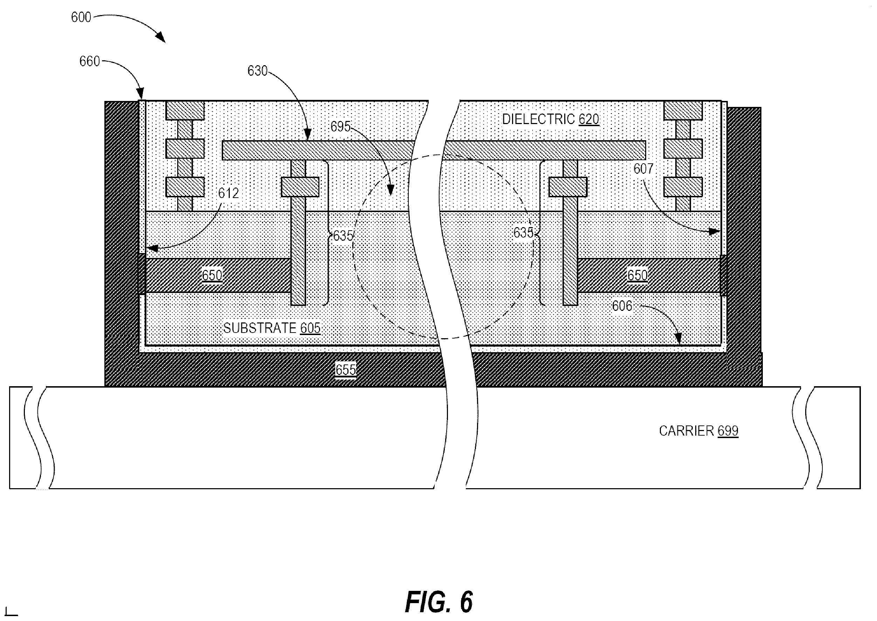

It will be appreciated that although FIG. 1A and other figures may depict a single buried interconnect 150 for purposes of illustration, devices according to embodiments herein can include any suitable number of buried interconnects which are electrically coupled to other structures and devices in any suitable fashion. As one nonlimiting example which will be described further in connection with FIG. 6, a buried interconnect can be electrically coupled to multiple devices in order to distribute a signal (e.g., a clock signal) to multiple devices or to couple multiple devices to an externally-generate supply voltage or to a reference voltage ("ground") node.

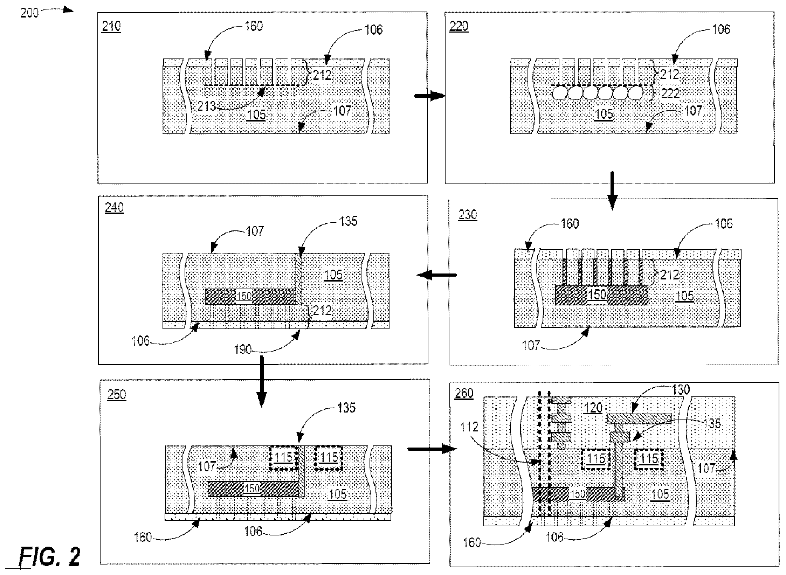

FIG. 2 is a process diagram showing steps in an example process suitable for use in fabricating a semiconductor die such as the die 100 according to one or more embodiments. The process 200 has steps 210, 220, 230, 240, 250, and 260 which are described in connection with fabrication of the die 100. It will be appreciated that in one or more embodiments, a die such as the die 100 is fabricated in a related process which may omit one or more steps of the process 200 or similar steps, perform steps of the process 200 or similar in a different order, or add steps not explicitly described in connection with the process 200. It will be further understood that well-known process steps may not be described and that multiple processing steps may be described as part of a single step of the process 200 for ease of understanding.

At step 210, dielectric material 160 is deposited or otherwise formed on the lower surface 106 of the substrate 105. It will be appreciated that the orientation of the substrate 105 is rotated relative to its orientation in FIG. 1A. The dielectric material 160 is patterned and used as an etch mask to etch vertical shafts 212 using a suitably anisotropic etch process. After this initial etch, the vertical shafts extend to the dashed line 213. As an example, the substrate 105 can be silicon and the dielectric material can be silicon nitride with any suitable stoichiometry. Additional dielectric material (e.g., additional silicon nitride) is deposited or otherwise formed such that the side walls of the vertical shafts 212 and the bottom of each shaft 212 is lined with the additional dielectric material. A subsequent anisotropic etch is used to remove the additional dielectric material from the bottom of each shaft 212, while leaving the sidewalls coated with the additional dielectric material.

Next, at step 220 a suitably selective anisotropic etch is used to selective removed the semiconducting material of the substrate 105 at the bottom of the vertical shafts 212 (at the dashed line 213) which creates the enlarged cavities 222 below the dashed line 213, as shown. As one non-limiting example, when the substrate 105 is silicon and the dielectric material 160 is silicon nitride, a plasma etch process using sulfur hexafluoride (SF₆ ) can be used to selectively and anisotropically etch the silicon to create the enlarged cavities. Subsequent annealing (e.g., in a hydrogen atmosphere) can be employed to cause the enlarged cavities to coalesce into a single cavity.

At step 230, a seed layer is deposited within the cavity (shown after the enlarged cavities have coalesced, now identified as the buried interconnect 150). For example, titanium nitride can be deposited by atomic layer deposition, followed by deposition of tungsten which fills the enlarged cavity and the vertical shafts 212. The metal in the vertical shafts above the cavity can be etched away using a suitably selective anisotropic etch and the holes in the bottom of each shaft 212 can then be plugged by forming tungsten nitride using an ammonia-based plasma process. A subsequent thermal oxidation process can seal the vertical shafts 212. It will be appreciated that in one or more embodiments vertical shafts such as the vertical shafts 212 are not sealed off and instead remain filled with metal.

At step 240, the cavity has been sealed as described above to form the buried interconnect 150. The positions of the vertical shafts 212 are indicated by dashed lines. As above, in one or more embodiments, the vertical shafts 212 can be left in the indicated positions and remain filled with metal or another suitable material. A portion of the TSV 135 can be formed using known techniques to form an electrical connection to the buried interconnect 150.

At step 250, devices 115 are formed within the semiconductor material of the substrate 105. Finally, at step 260 the dielectric layer(s) 120 is formed on the upper surface 107 of the substrate 105 and the interconnect 130 is formed, along with additional vertical structures such as the seal ring 140 and portions of the TSV 135 that extend into the dielectric material 120. At step 260 the substrate is also diced through the area indicated by dashed lines to singulate the die 100. In one or more embodiments, as shown in FIG. 2, a buried interconnect such as the buried interconnect 150 is disposed such that dicing the substrate exposes the buried interconnect at an edge of the die such as the edge 112 of the die 100.

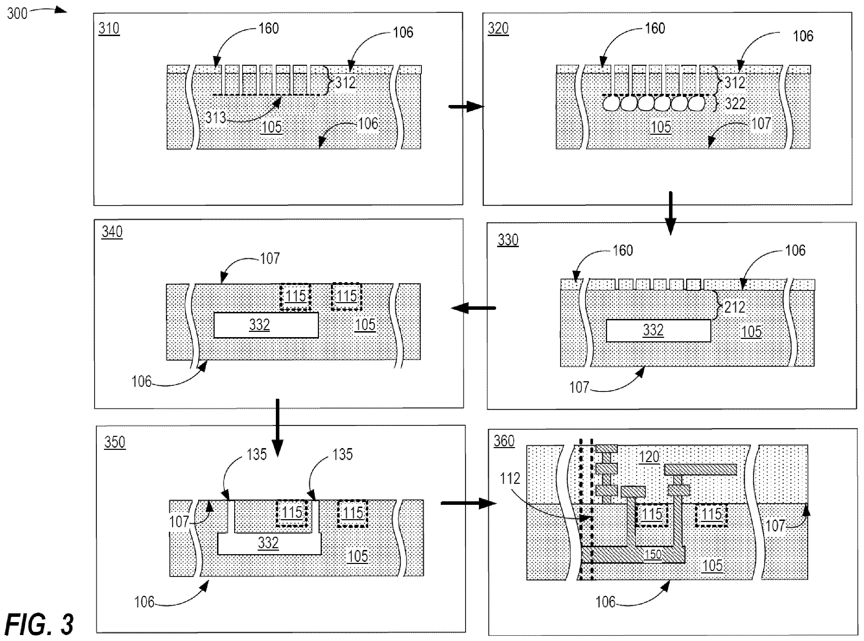

It will be appreciated that the process 200 is a so-called front-end-of-line (FEOL) process in which the buried interconnect 150 and associated structures are formed first, followed by fabrication of the devices 115 within the die 100. In one or more embodiments, a buried interconnect such as the buried interconnect 150 and associated structures are formed after devices such as the devices 115 are formed. Accordingly, FIG. 3 is a process diagram showing steps in an example back-end-of-line (BEOL) process suitable for fabrication of the die 100 in which the buried interconnect 150 is formed after fabrication of the devices 115.

The process 300 has steps 310, 320, 330, 340, 350, and 360 which are described in connection with fabrication of the die 100. It will be appreciated that in one or more embodiments, a die such as the die 100 is fabricated in a related process which may omit one or more steps of the process 300 or similar steps, perform steps of the process 300 or similar steps in a different order, or add steps not explicitly described in connection with the process 300. It will be further understood that well-known process steps may not be described and that multiple processing steps performed together or at different times may be described as part of a single step of the process 300 for ease of understanding.

At step 310, a dielectric material 390 has been deposited or otherwise formed on the lower surface 106 of the substrate 105 and patterned as shown. The dielectric material 160 (or other suitable masking material) is used as an etch mask for a suitable anisotropic etching process which forms the vertical shafts 312. Note that step 310 may be substantially similar to step 210 of the process 200 when performed with the substrate 105 oriented as shown.

Next, at step 320 a suitably selective anisotropic etch is used to selective removed the semiconducting material of the substrate 105 at the bottom of the vertical shafts 212 (at the dashed line 213) which creates the enlarged cavities 322 below the dotted line 313, as shown. As one non-limiting example, when the substrate 105 is silicon and the dielectric material 160 is silicon nitride, a plasma etch process using sulfur hexafluoride (SF₆ ) can be used to selectively and anisotropically etch the silicon to create the enlarged cavities. Note that step 320 may be substantially similar to portions of step 220 of the process 200 when performed with the substrate 105 oriented as shown. At step 330, the enlarged cavities 322 are annealed (e.g., in a hydrogen atmosphere) to form a hollow cavity 332. The vertical shafts 312 are closed by selective oxidation (e.g., thermal oxidation of silicon). In one or more embodiments, residual nitride or other dielectric material is anisotropically etched to expose the sidewalls of the vertical shafts 312 before closing them via the oxidation process.

At step 340, devices 115 are formed within the semiconductor material of the substrate 105. At step 350, after formation of the devices 115, trenches corresponding to the location of one or more TSVs 135 are etched or otherwise formed using any suitable process(es) to expose portions of the hollow cavity 332. The trenches corresponding to the TSVs 135 can be metallized using any suitable processes and materials, including but not limited to known processes for forming metallized vias in semiconductor substrates and can use metals or other electrically conductive materials suitable for use in such processes including, as nonlimiting examples, cobalt, tungsten, copper, and heavily-doped polysilicon.

Finally, at step 360 the dielectric layer 120 (or dielectric layers 120) is formed on the upper surface 107 of the substrate 105 and the interconnect 130 is formed, along with additional vertical structures such as the seal ring 140 and portions of the TSV 135 that extend into the dielectric material 120. At step 360 the substrate 105 is also diced through the area indicated by dashed lines to singulate the die 100. In one or more embodiments, dicing the substrate 105 exposes the buried interconnect 150 at the edge 112 of the substrate 105.

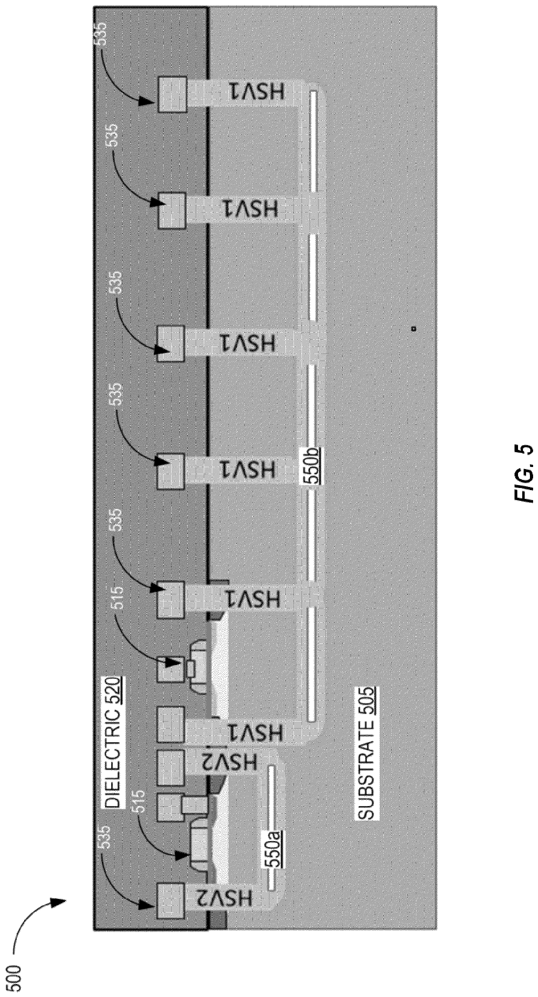

It will be appreciated that the process 300 and similar processes can be particularly useful for various applications, such as the example die 500 of FIG. 5 described below in which buried interconnects and vertical vias can be used together to provide power distribution or distribution of desired signals without requiring multiple layers of metallization above a substrate such as the substrate 105.

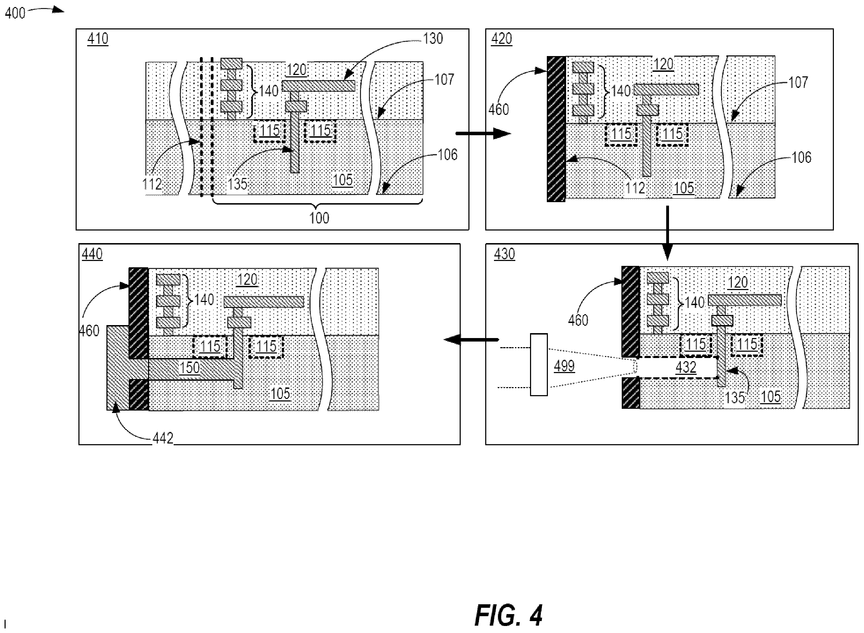

FIG. 4 is a process diagram showing steps in another example process suitable for use in fabricating a semiconductor die such as the die 100 according to one or more embodiments in which laser-drilling is used to form a buried interconnect such as the buried interconnect 150 after fabrication of devices such as the devices 115; vertical interconnects such as TSVs 135 or interconnects 137; horizontal interconnects such as the interconnect 130; and related structures. The process 400 has steps 410, 420, 430, and 400 which are described below in connection with fabrication of the die 100. It will be appreciated that in one or more embodiments, a die such as the die 100 is fabricated in a related process which may omit one or more steps of the process 400 or similar steps, perform steps of the process 400 or similar in a different order, or add steps not explicitly described in connection with the process 400. It will be further understood that well-known process steps may not be described and that multiple processing steps may be described as part of a single step of the process 400 for ease of understanding.

At step 410, the larger substrate or die is diced to singulate the die 100 and expose the edge 112 of the substrate 105. Next, at step 420, dielectric material 460 (e.g., dielectric material 160) is deposited or otherwise formed on the edge 112 of the substrate 105 and optionally on the edge of the dielectric layer(s) 120 as shown. The dielectric material 460 can be any suitable material including, but not limited to, a polyimide film.

At step 430 a focused radiation source 499 (e.g., a laser or other suitable radiation source) is used to etch or drill through the dielectric material 460 and through the semiconductor material of the substrate 105 as indicate by the dashed lines until the TSV 135 is encountered, forming a bore hole 432. The bore hole 432 can then be lined with dielectric material such as an oxide, nitride, or other material (not shown).

Next at step 440, the bore hole 432 is filled with any suitably electrically conductive material using any suitable process to form the buried interconnect 150. For example, the bore hole 432 may be filled with a metal such as copper, tungsten, nickel, or the like. Additional conductive material 442 may be deposited onto the edge 112 of the substrate 105 to form a macroscopic or otherwise enlarged contact pad along the edge 112 of the substrate 105.

FIG. 5 is a cross-sectional view of an example semiconductor die according to one or more embodiments with features enabled by one or more buried interconnects. The die 500 includes a semiconductor substrate 505 (e.g., a substrate 105), devices 515 formed within the semiconductor substrate 505 (e.g., devices 115) and buried interconnects 550 (buried interconnects 550a, 550b; e.g., buried interconnects 150), which can be formed using a process such as the process 300 (e.g., see the formation of multiple TSVs 135 enabling metallization of a previously hollow cavity 332 to form a buried interconnect 150 at steps 350 and 360). An extended buried interconnect such as the buried interconnect 550b coupled to multiple TSVs 535 (e.g., TSVs 135) can be coupled, for example, to an external supply voltage node via a TSV or an exposed surface of the buried interconnect at an edge of a die such as the die 500 (e.g., by dicing to expose the buried interconnect at one of the sidewalls of the die). TSVs such as the TSVs 535 can extend into a dielectric layer 520 (e.g., a dielectric layer 120) and can be positioned to allow for distribution of the supply voltage, a clock signal, or other electronic signal to multiple devices positioned above the buried interconnect along its length. Additional interconnects can be routed to connect the TSVs 535 to devices or other structures as desired using well-known techniques for forming metallization layers (e.g., redistribution layers or build-up layers) in semiconductor devices.

FIG. 6 is a cross-sectional view of another example semiconductor die with features according to one or more embodiments. The die 600 includes a semiconductor substrate 605 (e.g., a substrate 105, 505) with a lower surface 606 and an upper surface 607. A dielectric layer 620 or multiple dielectric layers 620 (e.g., dielectric layer(s) 120 or 520) are disposed on the upper surface 607. Horizontal electrical interconnects such as the interconnect 630 (e.g., interconnects 130 or 530) can extend within the dielectric layer(s) 620 to couple TSVs such as the TSVs 635 to each other and/or to other structures or devices. The buried interconnects 650 (e.g., buried interconnects 150 or 550) are each coupled to an external electrically conductive structure 655 that surrounds the die 600 at respective edges 612 of the die 600. The buried interconnects are also electrically coupled to respective TSVs 635 within the substrate 605 and the two TSVs 635 are coupled to each other as shown via the horizontal interconnect 630. As a result, it will be appreciated that that continuous electrically conductive path is formed around central region 695 of the substrate 605 as indicated by a dashed circle. This conductive path can be grounded (i.e., coupled to reference potential node) or biased to a desired electrical potential in order to shield components formed within the central region 695 from receiving external electrical interference or from becoming a source of electrical interference to external devices.

It will be understood that FIG. 6 shows a cross-sectional view of the die 600 and that in one or more embodiments additional buried interconnects can be connected to a conductive structure such as the conductive structure 655 that extend in directions that are parallel, partially parallel or perpendicular to the buried interconnects 650 as shown in the example of FIG. 6 to form an extended shielded region with a die such as the die 600.

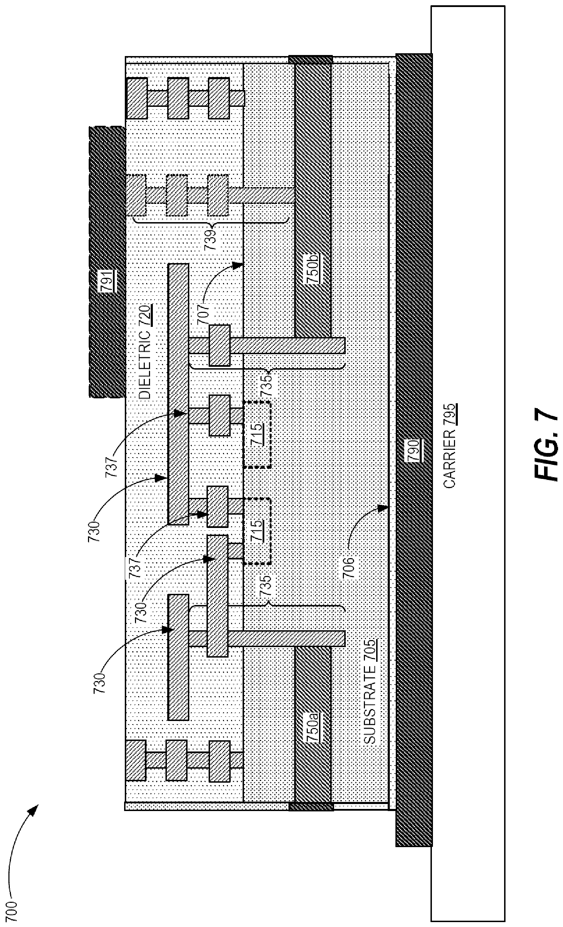

FIG. 7 is a cross-sectional view of another example semiconductor die with features according to one or more embodiments. The die 700 includes a semiconductor substrate 705 (e.g., a substrate 105, 505, or 605) with a lower surface 706 and an upper surface 707. One or more dielectric layer(s) 720 (e.g., one or more dielectric layers 120, 520 or 620) is disposed on the upper surface 707. Horizontal electrical interconnects such as the interconnects 730 (e.g., interconnects 130, 530, or 630) can extend within the dielectric layer(s) 720 to couple TSVs such as the TSVs 735 to each other and/or to other structures or devices.

The buried interconnects 750 (e.g., buried interconnects 150, 550, or 650; represented by the buried interconnects 750a, 750b) can each be coupled to external structures or devices. For example, the die 700 is shown mounted to a metallized structure 790 on a carrier substrate 795 (e.g., a printed circuit board or any other suitable carrier substrate). The metallized structure 790 may be part of (or coupled) to a voltage distribution node coupled to a supply voltage, a ground plane or other reference potential node, or to a signal source (e.g., a clock signal generator or any other signal source). As a result, circuit nodes or other structures of the die 700 can be easily coupled to a ground potential (or any circuit node or signal line). Notably, the arrangement pictured in FIG. 7 allows devices 715 (e.g., devices 115, 515, or 615) to be coupled to external contacts (i.e., the portions of the buried interconnects 750 exposed along the edges 712 of the die 700) without requiring TSVs or other conductive structures to be fabricated underneath the devices 715 (i.e., within the semiconductor substrate 705). It will be understood that FIG. 7 shows a cross-sectional view of the die 700 and that in one or more embodiments additional buried interconnects can be routed within a die that extend in directions that are parallel, partially parallel or perpendicular to the buried interconnects 750 as shown in the example of FIG. 7.

In one or more embodiments, as shown in FIG. 7, a buried interconnect such as one of the buried interconnects 750 can be coupled to an external contact or other structure disposed above one or more redistribution layers such as the dielectric layer(s) 720 via TSV such as the optional TSV 739 which is coupled to a conductive structure 791. In one example, a first conductive structure such as the conductive structure 790 is coupled to a ground plane or other reference potential node and a second conductive structure such as the conductive structure 791 is coupled to a supply voltage node (or vice versa) to distribute supply voltage and ground connections to multiple devices such as the devices 715 and/or other structures within a die such as the die 700. In one or more embodiments, one or more supply and ground connections can be instead made via connections to a buried interconnect at edges of the die (e.g., to a portion of the buried interconnect 750a or a portion of the buried interconnect 750b exposed at edges of the die 700). Conducive structures such as the conductive structures 790, 791 can extend over all or a portion of surfaces of a die such as the die 700 and/or they can wrap around edges of such a die. As one non-limiting example, the conductive structure 790 could wrap around an edge of the die 700 to contact the buried interconnect 750a directly and the conductive structure 791 could wrap around an opposite edge of the die 700 to contact the buried interconnect 750b directly.

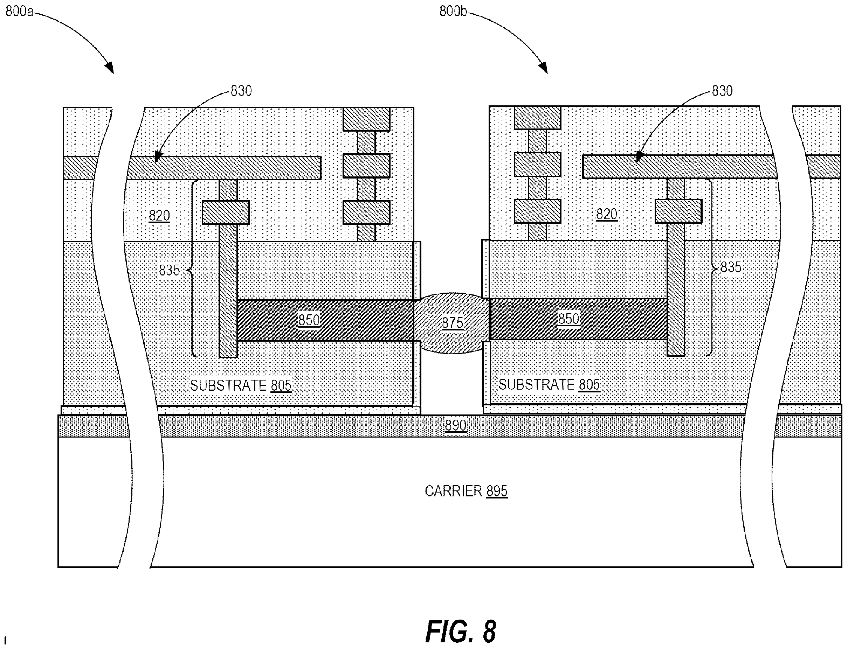

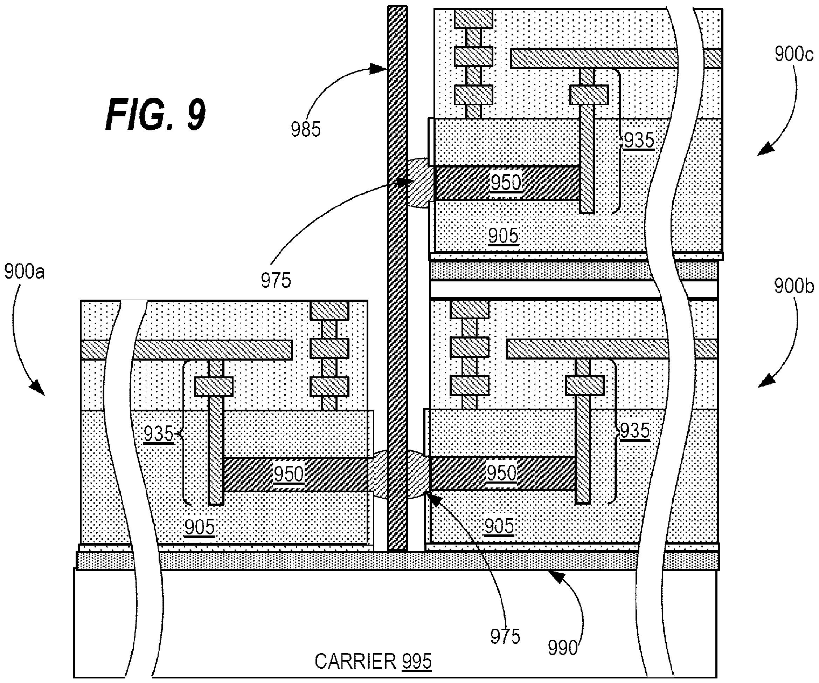

Die with buried interconnects according to embodiments herein can provide greater flexibility to assemble multiple die or other components into multichip packages. Along these lines FIG. 8 and FIG. 9 show examples of components that include multiple die that are electrically and/or mechanically coupled to each other via contacts to buried interconnects exposed along one or more edges of each die.

FIG. 8 shows a component that includes two semiconductor die 800 (die 800a, 800b; e.g., die 100, 500, 600, or 700) disposed on a carrier substrate 895. For ease of understanding, the die 800a, 800b are depicted as mirror images of each other. However, it will be appreciated that nothing herein is intended to limit the configuration of components according to embodiments herein to such an arrangement, or to any particular number or configuration of TSVs, horizontal interconnects, and so on. As one example, either of the die 800 can include devices formed within a device region of a substrate 805 (e.g., the device region 110 of the die 100).

In the example of FIG. 8, each die 800 includes a semiconductor substrate 805 with a buried interconnect 850 (e.g., a buried interconnect 150, 550, 650, or 750) formed within a volume of semiconductor material of the substrate 805 between a lower surface 806 and upper surface 807 of that substrate. A TSV 835 (e.g., a TSV 135, 535, 635, or 735) is electrically coupled to the buried interconnect 850 and in turn coupled to a horizontal interconnect 830 (e.g., an interconnect 130, 530, 630, or 730) which can be electrically coupled to one or more devices (e.g., devices 115, 515, 615 or 715) via electrical interconnects in one or more redistribution layers (e.g., the horizontal interconnect 830 shown; a TSV 135, 535, 635 or 735; or a vertical electrical interconnect 137 or 737, or the like). The die 800 are bonded to the carrier substrate 895 via bonding layer 890 which can be any suitable material. For example, the bonding layer 890 can be an electrically conductive or insulating polymeric material, a dielectric material, or a metallic material.

Once secured to the carrier substrate 895, die such as the two die 800 can be directly coupled to each other via a volume of conductive material 875, which can be any suitable material. Thus in one or more embodiments, two die may be coupled together via a volume of conductive adhesive that bonds two buried interconnects together at respective edges of each die. Similarly, in one or more embodiments, two die may be coupled together via a volume of electrically conductive solder that bonds two buried interconnects together at respective edges of each die. In addition, in one or more embodiments, two die may be coupled together via a volume of electrically conductive sintered die attachment material that bonds two buried interconnects together at respective edges of each die.

FIG. 9 illustrates another example component in which multiple semiconductor die and/or related structures can be stacked in two or more tiers and interconnected using buried interconnects exposed at edges of those die. In the example of FIG. 9, the die 900a and 900b are disposed side by side and include respective buried interconnects 950 which can be coupled to devices and other structures within each die via TSVs 935 and additional interconnects within one or more redistribution layers such as the horizontal interconnects 930 pictured. The die 900a, 900b can be directly coupled to each other similarly to the die 800a, 800b of FIG. 8 or, as shown in the example of FIG. 9, they can be coupled via respective volumes of conductive material 975 (e.g., conductive material 875) to an electrically conductive vertical lead 985. In this example, the die 900a, 900b are disposed on a bonding layer 990 that couples them to the carrier substrate 995. The bonding layer 990 may be metallic and in one or more embodiments, a vertical lead such as vertical lead 985 is metallurgically bonded to a bonding layer such as the bonding layer 990. In the example of FIG. 9 The die 900c is disposed on top of the die 900b and is also electrically coupled to the vertical lead 985 as shown. The bonding layer 990 or an equivalent structure may be a ground plane or otherwise coupled to a reference voltage node. In one or more embodiments, portions of a die such as a die 900 can be grounded by being bonded to a vertical lead such as the vertical lead 985.

It will be understood that embodiments herein related to the example of FIG. 9 can include any number of die with any suitable number of buried interconnects in any suitable configuration coupled to any suitable number of vertical leads in any suitable configuration. For example, dedicated vertical leads can be connected to only one buried interconnect or buried interconnects of only one die, but not others. In addition, vertical interconnects can be coupled to vias, interconnects in redistribution layers on a carrier such as the carrier substrate 895 or any other structures. Multiple vertical leads can also be bundled together and separated from each via insulating material to form a vertical redistribution structure (analogous to conventional redistribution layers disposed on surfaces of die in which horizontal interconnects are routed in different levels and connected via TSVs or other vertical interconnects) to which various die can be selectively coupled via corresponding edge contacts made to buried interconnects such as buried interconnects 950. It will be understood that structures such as those depicted in the example of FIG. 9 and other examples herein may be encapsulated or otherwise enclosed within a larger device package which is not shown.

### VARIOUS EXAMPLES

Features of embodiments may be understood by way of one or more of the following examples:
Example 1: A device or method that includes a first semiconductor die having an upper surface, a lower surface, and a first volume of semiconductor material between the upper surface and the lower surface. Electronic devices integrally are formed in a first device region that forms part of the first volume of semiconductor material. A first electrically-conductive buried interconnect is formed within the first volume of semiconductor material between the first device region and the lower surface of the first semiconductor die and extends from an interior portion of the first semiconductor die toward a first edge of the first semiconductor die along a lateral direction that is parallel to the upper and lower surfaces of the first semiconductor die. The first edge extends between the upper surface and the lower surface of the first semiconductor die.
Example 2: The device or method of Example 1 that also includes an electrically-conductive first via that extends vertically through the first device region of the first volume of semiconductor material and is electrically coupled to the first buried interconnect within the first volume of semiconductor material.
Example 3: The device or method of Example 1 or Example 2 where the first buried interconnect is electrically coupled to one or more of the electronic devices of the first device region.
Example 4: The device or method of any of Examples 1-3 where the first via is formed of a first electrically-conductive material and the first buried interconnect is formed of a second electrically-conductive material.
Example 5: The device or method of any of Examples 1-4 that also includes: A metallic seal-ring structure formed on the upper surface of the first semiconductor die above the first volume of semiconductor material, where the metallic seal-ring structure surrounds a central portion of the upper surface of the first semiconductor die; where a portion of first the buried interconnect between the interior portion and the first edge of the first semiconductor die passes underneath the seal-ring structure.
Example 6: The device or method of any of Examples 1-5 that further includes a circuit substrate disposed next to the first semiconductor die that has an upper surface, a lower surface, and a first edge that extends between the upper surface and the lower surface of the circuit substrate; an electrical contact that is exposed at the first edge of the circuit substrate; and a volume of electrically conductive material that electrically couples the electrical contact of the circuit substrate to the first buried interconnect of the first semiconductor die.
Example 7: The device or method of any of Examples 1-6 where the circuit substrate is a second semiconductor die. The second semiconductor die includes electronic devices integrally formed in a second device region that forms part of a volume of semiconductor material disposed between the upper surface and the lower surface of the second semiconductor die; and a second electrically-conductive buried interconnect formed within the second volume of semiconductor material between the second device region and the lower surface of the second semiconductor die and extending from an interior portion of the second semiconductor die toward a first edge of the second semiconductor die along a lateral direction that is parallel to the upper and lower surfaces of the second semiconductor die. The second buried interconnect is coupled to the electrical contact that is exposed at the first edge of the circuit substrate.
Example 8: The device or method of any one of Examples 1-7 where the semiconductor die is disposed on a carrier substrate and including an electrically conductive extended lead facing the first edge of the first semiconductor die and extending vertically from the carrier substrate. The first semiconductor die is coupled to the extended lead at a first location along the extended lead via a volume of electrically conductive material that is coupled to the first buried interconnect at the first edge of the first semiconductor die. An additional die is electrically coupled to the extended lead at a second location along the extended lead that is disposed above the first location.
Example 9: The device or method of any one of Examples 1-8 where the semiconductor die is disposed on a carrier substrate and the first buried interconnect includes one or more vertical shafts lined with metal which extend toward the lower surface of the first semiconductor die that are exposed at the bottom surface of the first semiconductor die. The semiconductor die is metallurgically bonded to the carrier substrate via material of the one or more vertical shafts that is exposed at the bottom surface of the first semiconductor die.
Example 10: The device or method of any one of Examples 1-9 where the first buried interconnect is coupled to a supply voltage node or a reference voltage node. The first buried interconnect forms part of an electrically-conductive supply voltage manifold configured to distribute electrical power from the supply voltage node to multiple electronic devices within the first device region.
Example 11: The device or method of any of Examples 1-10 where the first buried interconnect extends from the interior portion of the first semiconductor die to the first edge of the first semiconductor die along the lateral direction that is parallel to the upper and lower surfaces of the first semiconductor die. The first buried interconnect is exposed at the first edge of the first semiconductor die.
Example 12: A device or method that includes a first semiconductor die having an upper surface, a lower surface, and a first volume of semiconductor material disposed between the upper surface and the lower surface; electronic devices integrally formed in a first device region that forms part of the first volume of semiconductor material. A first electrically-conductive buried interconnect is formed within the first volume of semiconductor material between the first device region and the lower surface of the first semiconductor die and the first buried interconnect extending along a lateral direction that is parallel to the upper and lower surfaces of the first semiconductor die.
Example 13: The device or method of Example 12, where the first buried interconnect is coupled to a voltage distribution node and where the first buried interconnect forms part of an electrically-conductive voltage distribution manifold configured to distribute electrical power or an electrical signal from the voltage distribution node to multiple electronic devices within the first device region or to couple the multiple electronic devices within the first device region to the voltage distribution node.
Example 14: The device or method of Example 12 or Example 13, where the voltage distribution manifold includes an electrically-conductive first vertical interconnect that extends vertically through the first device region of the first volume of semiconductor material and is electrically coupled to the first buried interconnect within the first volume of semiconductor material.
Example 15: The device or method of any one of Examples 12-14, where the first vertical interconnect couples the first buried interconnect to the voltage distribution node.
Example 16: The device or method of any one of Examples 12-15, where the first vertical interconnect is coupled to a conductive contact disposed on a surface of the first semiconductor die that is above or below the first buried interconnect that is configured to couple the first vertical interconnect to the voltage distribution node.
Example 17: The device or method of any one of Examples 12-16, where the first vertical interconnect via further extends above the first device region into dielectric material disposed above the first device region and the voltage distribution manifold includes the first vertical interconnect and additional electrical interconnections within the dielectric material.
Example 18: The device or method of any one of Examples 12-17, where the voltage distribution node is a supply voltage node or a reference potential node.
Example 19: The device or method of any of Examples 12-18 where the first buried interconnect is electrically coupled to one or more of the electronic devices of the first device region.

The preceding detailed description and examples are merely illustrative in nature and are not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

It should be understood that this invention is not limited in its application to the details of construction and the arrangement of components set forth in the preceding description or illustrated in the accompanying drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The preceding discussion is presented to enable a person skilled in the art to make and use embodiments of the invention. Various modifications to the illustrated embodiments will be readily apparent to those skilled in the art, and the generic principles herein can be applied to other embodiments and applications without departing from embodiments of the invention. Thus, embodiments of the invention are not intended to be limited to embodiments shown, but are to be accorded the widest scope consistent with the principles and features disclosed herein. The preceding detailed description is to be read with reference to the figures, in which like elements in different figures have like reference numerals. The Figures, which are not necessarily to scale, depict selected embodiments and are not intended to limit the scope of embodiments of the invention. Skilled artisans will recognize the examples provided herein have many useful alternatives and fall within the scope of embodiments of the invention.

The connecting lines shown in the various figures contained herein are intended to represent exemplary functional relationships and/or physical couplings between the various elements. It should be noted that many alternative or additional functional relationships or physical connections may be present in one or more embodiments of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in one or more embodiments of the depicted subject matter.

## Claims

1. An electronic component, comprising:
a first semiconductor die having an upper surface, a lower surface, and a first volume of semiconductor material between the upper surface and the lower surface;
electronic devices integrally formed in a first device region that forms part of the first volume of semiconductor material;
a first electrically-conductive buried interconnect formed within the first volume of semiconductor material between the first device region and the lower surface if the first semiconductor die and extending from an interior portion of the first semiconductor die to a first edge of the first semiconductor die along a lateral direction that is parallel to the upper and lower surfaces of the first semiconductor die;
wherein the first edge extends between the upper surface and the lower surface of the first semiconductor die; and
wherein the first buried interconnect is exposed at the first edge of the first semiconductor die.

2. The electronic component of Claim 1, further comprising an electrically-conductive first via that extends vertically through the first device region of the first volume of semiconductor material and is electrically coupled to the first buried interconnect within the first volume of semiconductor material.

3. The electronic component of Claim 2 wherein the first buried interconnect is electrically coupled to one or more of the electronic devices of the first device region.

4. The electronic component of Claim 2 or 3, wherein the first via is formed of a first electrically-conductive material and the first buried interconnect is formed of a second electrically-conductive material.

5. The electronic component of any of Claims 2 to 4, further comprising:
a metallic seal-ring structure formed on the upper surface of the first semiconductor die above the first volume of semiconductor material, wherein the metallic seal-ring structure surrounds a central portion of the upper surface of the first semiconductor die;
wherein a portion of first the buried interconnect between the interior portion and the first edge of the first semiconductor die passes underneath the seal-ring structure.

6. The electronic component of any of Claims 2 to 5, further comprising:
a circuit substrate disposed next to the first semiconductor die that has an upper surface, a lower surface, and a first edge that extends between the upper surface and the lower surface of the circuit substrate;
an electrical contact that is exposed at the first edge of the circuit substrate; and
a volume of electrically conductive material that electrically couples the electrical contact of the circuit substrate to the first buried interconnect of the first semiconductor die.

7. The electronic component of Claim 6, wherein the circuit substrate is a second semiconductor die, the second semiconductor die comprising:
electronic devices integrally formed in a second device region that forms part of a volume of semiconductor material disposed between the upper surface and the lower surface of the second semiconductor die; and
a second electrically-conductive buried interconnect formed within the second volume of semiconductor material between the second device region and the lower surface of the second semiconductor die and extending from an interior portion of the second semiconductor die to a first edge of the second semiconductor die along a lateral direction that is parallel to the upper and lower surfaces of the second semiconductor die;
wherein the second buried interconnect is coupled to the electrical contact that is exposed at the first edge of the circuit substrate.

8. The electronic component of any of Claims 2 to 7,
wherein the semiconductor die is disposed on a carrier substrate;
wherein the component further comprises an electrically conductive extended lead facing the first edge of the first semiconductor die and extending vertically from the carrier substrate;
wherein the first semiconductor die is coupled to the extended lead at a first location along the extended lead via a volume of electrically conductive material that is coupled to the first buried interconnect at the first edge of the first semiconductor die; and
wherein an additional die is electrically coupled to the extended lead at a second location along the extended lead that is disposed above the first location.

9. The electronic component of any of Claims 2 to 8,
wherein the semiconductor die is disposed on a carrier substrate;
wherein the first buried interconnect includes one or more vertical shafts lined with metal which extend toward the lower surface of the first semiconductor die and are exposed at the bottom surface of the first semiconductor die; and
wherein the semiconductor die is metallurgically bonded to the carrier substrate via material of the one or more vertical shafts that is exposed at the bottom surface of the first semiconductor die.

10. The electronic component of any preceding Claim,
wherein the first buried interconnect is coupled to a supply voltage node or a reference voltage node; and
wherein the first buried interconnect forms part of an electrically-conductive supply voltage manifold configured to distribute electrical power from the supply voltage node to multiple electronic devices within the first device region.
